# EUROPÄISCHE PATENTSCHRIFT

(11) **EP 1 199 726 B1**
(45) Veröffentlichungstag und Bekanntmachung des Hinweises auf die Patenterteilung: **25.08.2004**
(21) Anmeldenummer: 01128982.4
(22) Anmeldetag: 15.12.1998
(51) Int. Cl.: G11C 29/00, G01R 31/3193

(54) **Verfahren und Vorrichtung zur Prüfung von integrierten Schaltkreisen**
Method and apparatus for testing integrated circuits
Procédé et dispositif d'essai de circuits integrés

(30) Priorität: 22.12.1997 DE 19757200
(43) Veröffentlichungstag der Anmeldung: 24.04.2002
(62) Teilanmeldung aus: 98966545.0
(73) Patentinhaber: PACT XPP Technologies AG, 80939 Munchen (DE)
(72) Erfinder: Vorbach, Martin, 80689 München (DE); Münch, Robert, 76149 Karlsruhe (DE)
(74) Vertreter: Pietruk, Claus Peter, Dipl.-Phys.

(56) Entgegenhaltungen:
- US-A- 5 072 178

## Beschreibung

### 1. Hintergrund der Erfindung

### 1.1 Stand der Technik

### 1.1.1 Mehrdimensionale Arrays aus Rechenwerken

Aus DE 196 51 075.9-53 sind Prozessoren mit einer Mehrzahl von 2- oder mehrdimensional angeordneten Rechenwerken/Zellen bekannt. Die Rechenleistung derartige Prozessoren steigt mit der Zahl der vorhandenen Rechenwerken an. Daher wird versucht möglichst viele Rechenwerke auf einen Chip zu integrieren, wodurch die benötigte Fläche ansteigt. Mit steigender Fläche, wächst gleichzeitig die Wahrscheinlichkeit, dass der Chip bereits bei der Herstellung Fehler aufweist und unbrauchbar ist. Demselben Problem unterliegen alle in Matrix-Form angeordnete Rechenwerke, z.B. auch andere bekannte bekannten Typen wie DPGAs, Kress-Arrays, Systolische Prozessoren und RAW-Machines; genauso wie einige Digitalen Signalprozessoren (DSPs), die mehr als ein Rechenwerk besitzen.
Gleichzeitig sind allen genannten Typen sehr testintensiv, d.h. um die Fehlerhaftigkeit nachzuweisen müssen besonders viele Testfälle in bezug auf die Funktion der Zellen und Vernetzung generiert und getestet werden. Herkömmliche bekannte Methoden wie BIST, Boundary Scan, etc. sind aufgrund der erheblichen Menge an Testvektoren schlecht zu integrieren und zu zeit- und platzintensiv.

### 1.1.2 Standardprozessoren

Standardprozessoren wie beispielsweise die bekannte x86-Reihe, MIPS oder ALPHA besitzen mehrere Rechenwerke, die zeitversetzt oder durch einen VLIW-Befehl gleichzeitig angesteuert werden. In Zukunft wird die Zahl der integrierten Recheneinheiten (Integer-Units) und Fließkomma-Rechenwerke (Floating-Point-Units) weiter ansteigen. Jedes der Rechenwerke muß ausreichend getestet werden und weitestgehend fehlerfrei sein.

### 1.2 Probleme

### 1.2.1 Mehrdimensionale Arrays aus Rechenwerken

Durch die steigende Fehlerwahrscheinlichkeit bei großen Chips können entweder nur sehr wenige Zellen integriert werden, oder die Produktionskosten werden bedingt durch den entstehenden Ausschuß erheblich. Bei sehr großen Chips wird eine maximale Fläche erreicht, über der hinaus kein funktionsfähiger Chip mehr hergestellt werden kann.
Durch den Zeitaufwand beim Testen nach herkömmlichen Verfahren steigen die Testkosten stark an. Eingebaute BIST-Funktionen (Build In Self Test) verschwenden durch hohen Zusatzaufwand sehr viel Fläche, die die Kosten nach oben treibt und die Herstellbarkeit verringert. Zudem steigt die Wahrscheinlichkeit stark an, dass ein Fehler nicht innerhalb der eigentlichen Funktionseinheiten sonderen innerhalb der Teststrukturen liegt.

### 1.2.2 Standardprozessoren

Durch die steigende Zahl der Rechenwerke steigt die Fehlerwahrscheinlichkeit an. Dadurch bedingt wird der Ausschuß höher, wodurch die Herstellungskosten steigen. Mit wachsender Fläche und der damit verbundenen Steigerung der Transistormenge wächst die Ausfallwahrscheinlichkeit bei der Benutzung. Bezüglich des Testaufwandes und der BIST-Implementierung gilt das bereits für "Mehrdimensionale Arrays aus Rechenwerken" Gesagte.

### 1.2.3

Aus der US-PS 5,072,178 ist ein Verfahren zum Testen eines Logikschaltkreises bekannt, welches Daten verändern kann, wobei eine Testapparatur und eine Vorrichtung beschrieben werden. Die bekannte Logikschaltkreistestvorrichtung weist einen ersten Speicher auf, um Testdaten einschließlich einer Vielzahl von Testmustern zu speichern, und einen zweiten Speicher, um jedes der Testmuster in Übereinstimmung mit einer Gruppe von Testeranschlüssen zu speichern und weist weiter einen Transferschaltkreis mit einem Datenkonverter auf, um die Testmuster aus dem ersten Speicher und einem dritten Speicher zu ändern, um Kontrolldaten festzulegen, um den Datenkonverter zu kontrollieren.

### 1.3 Verbesserung durch die Erfindung, Aufgabe

Gemäß der vorliegenden Erfindung ist es möglich defekte Zellen durch Funktionsfähige zu ersetzen und damit den Ausschuß zu verringern. Dabei kann eine Ersetzung entweder mittels Testsystemen bei der Herstellung der Chips erfolgen oder sogar beim Anwender im komplett aufgebauten System.
Es ist möglich Testvektoren gemäß dem BIST-Prinzip innerhalb des Chips, als auch gemäß einem neuen Verfahren außerhalb des Bausteins zu generieren, um Fläche und Kosten zu sparen. Weiterhin wird eine Möglichkeit beschrieben, wie Chips automatisch Defekte reparieren können, ohne dass ein externes zusätzliches Werkzeug dafür notwendig ist.
Sämtliche Tests und Reparaturen können zur Laufzeit der Chips durchgeführt werden.
Diese Aufgabe wird enfindungsgemäß durch die Merkmale der unabhängige Ansprüche 1 and 2 gelöst.
Der abhängige Anspruch 3 spezifiert eine zweckmäßige Ausgestaltung des Gegestandes ihres Hanptanspruchs.

### 2. Beschreibung der Erfindung

### 2.1 Detailbeschreibung der Erfindung

### 2.1.1 Ersetzen defekter Zellen

Einer Gruppe von Zellen, die im Weiteren in Anlehnung an DE 196 51 075.9-53 mit PAEs bezeichnet werden, wird eine zusätzliche, im normalen Betrieb nicht benutzte PAE zugeordnet (die im Folgenden PAER genannt wird). Die Zellen können Rechenwerke jeder Art, konfigurierbare (programmierbare) Logikzellen oder andere Cores beliebiger Funktion sein. Bei der Gruppierung der PAEs und der Zuordnung der PAER ist eine spaltenoder zeilenweise Gruppierung der PAEs vorzuziehen, da hierdurch die Vernetzung vereinfacht wird. In Hinblick auf zukünftige Chiptechnologien, wird auf eine mögliche Gruppierung der PAEs innerhalb einer 3. Dimension hingewiesen. Vor die Eingänge der PAEs werden derart Multiplexer geschaltet, dass der Eingang ersten PAE in der Zeile/Spalte auch auf den Eingang der zweiten PAE in der Zeile/Spalte geschaltet werden kann, wobei dann auch der Eingang der zweiten PAE auf den Eingang der dritten PAE geschaltet wird und so weiter. Der Eingang der letzten PAE wird auf den Eingang der PAER geschaltet. Das bedeutet, dass bei einem Defekt der ersten PAE deren Funktion durch die Zweite, die Funktion der Zweiten durch die Dritte und so weiter ersetzt wird, bis die Funktion der letzten PAE durch die PAER ersetzt wird. Ist eine PAE innerhalb der Spalte/Zeile defekt, werden die vor ihr liegenden PAEs normal beschaltet und ab der Stelle der defekten PAE alle Funktionen um eine PAE verschoben. Ist beispielsweise die PAE 4 defekt, so führen die PAEs 1..3 ihre jeweilige Funktion aus, während der Eingangsmultiplexer der PAE 5 so geschaltet ist, dass er die Daten der PAE 4 erhält, der Eingangsmultiplexer der PAE 6 erhält die Daten der PAE 5 und so weiter, bis der Eingang der PAER die Daten der letzten PAE erhält.

Um die Ergebnisse wieder in der richtigen Reihenfolge der Vernetzung zuzuführen werden an den Ausgängen der PAEs ebenfalls Multiplexer angebracht, wobei der Ausgangsmultiplexer der PAE 1 entweder die PAE 1 auf den Bus schaltet - sofern diese nicht defekt ist - oder bei einem Defekt den Ausgang der PAE 2 auf den Bus schaltet, an Stelle der PAE 2 wird dann die PAE 3 auf den Bus geschaltet, bis hin zur letzten PAE, an deren Stelle die PAER aufgeschaltet wird. Befindet sich die defekte PAE in der Mitte der Zelle/Spalte, so erfolgt eine Verschiebung der Ausgänge in genau der Art, wie sie für die Eingänge bereits beschrieben wurde.
Speziell bei konfigurierbarer Logik und konfigurierbaren Rechenwerken, treten zusätzliche Bussysteme auf, um die Konfigurationsdaten zu übermitteln und die Konfiguration zu steuern. Diese Bussysteme werden entsprechend der in diesem Abschnitt genannten Busse ebenfalls über Multiplexer verschaltet. Gleiches gilt für die Bussysteme, über die bei einer matrixartigen Anordnung von Rechenwerken (z.B. Systolische Prozessoren, SIMD, etc), die Befehle in die jeweiligen Rechenwerke geschrieben werden.
Grundsätzlich kann jeder Bus oder jedes Signal über Multiplexer geleitet werden. Je nach Anforderung an die Ausfallsicherheit kann beispielsweise das Taktsignal über Multiplexer geführt werden, um einem eventuellen Kurzschluß vorzubeugen; oder das Taktsignal wird direkt an die Zelle geführt, weil ein derartiger Ausfall nicht abgefangen werden soll. Die Stufe der Ausfallsicherheit kann konstruktiv entsprechend den Anforderungen für jedes Signal oder jeden Bus einzeln festgelegt werden.

### 2.1.2 Ersetzen defekter Busse

Das vorgestellte Konzept zur Fehlerkorrektur innerhalb von Gatterstrukturen ist in gleicher Weise auf Bussysteme anwendbar. Dabei wird einer Anzahl von Bussen (Bus 1 ... Bus n) ein zusätzlicher Bus (BUS R) zugeordnet. Ist einer der Busse defekt (BUS d), wird seine Funktion von einem seiner Nachbarbusse übernommen (BUS (d + 1)). Die Funktion des Nachbarbusses (BUS (d + 1)) wird von dessen Nachbarbus (BUS (d + 2)) übernommen, usw., wobei die Richtung des übernehmenden Busse immer die gleiche bleibt. So lange, bis BUS n durch BUS R übernommen wird.
Bei der Anwendung der Multiplexer-Strukturen auf Bussysteme werden entsprechend der vorliegenden Verbindungsstruktur und der Richtung der Daten gewöhnliche Multiplexer, Dekoder und Gates, Tristate-Gatter, oder Bidirektionale Multiplexer eingesetzt.

### 2.1.3 Dekoder

Es ist offensichtlich, dass immer zwei Gruppen von aufeinanderfolgenden Multiplexern denselben Zustand annehmen müssen, d.h. MUX 1 = MUX 2 = MUX3 = ... = MUX n = Zustand A und MUX (n + 1) = MUX (n + 2) = MUX (n + 3) = ... = MUX m = Zustand B.
Ist keine PAE defekt gilt MUX 1 = MUX 2 = ... = MUX m = Zustand A.
Ist die erste PAE defekt gilt MUX 1 = MUX 2 = ... = MUX m = Zustand B.
Ist beispielsweise PAE 3 defekt gilt MUX 1 = MUX 2 = Zustand A, MUX 3 = MUX 4 = ... = MUX m = Zustand B, wobei in diesem Beispiel PAER der PAE m zugerordnet ist, d.h. PAER befindet sich direkt neben PAE m.

Die Ansteuerung der Multiplexer sieht daher beispielsweise wie folgt aus

| Defekte PAE | Multiplexer Ansteuerung |
|---|---|
| keine | 0000...000 |
| m | 0000...001 |
| m-1 | 0000...011 |
| m-2 | 0000...111 |
| 4 | 0001...111 |
| 3 | 0011...111 |
| 2 | 0111...111 |
| 1 | 1111...111 |

Ist die PAER der PAE 1 zugeordnet, so ist die Reihenfolge m...1 vertauscht (Defekte PAE 1 entspricht 0000...001, bzw. defekte PAE m entspricht 1111...111).

Es ist daher ausreichend die Nummer der defekten PAE zu speichern und diese einem Dekoder zuzuführen, der anhand der oben abgebildeten Tabelle die Zustände der Multiplexer ansteuert.

### 2.1.4 Durchführung des Selbsttests

Grundsätzlich können beliebige Teststrategien auf das Verfahren angewendet werden, wobei das folgende erfindungsgemäße Verfahren als besonders geeignet angesehen wird:
Das Array aus PAEs wird mit einem oder mehreren Testalgorithmen geladen, die ein oder mehrere Testvektoren berechnen. An einer Kante des Arrays werden die PAEs als Vergleicher geschaltet, so dass die anhand der Testvektoren berechneten Werte mit den Sollergebnissen verglichen werden. Entspricht das berechnete Ergebnis nicht den Sollergebnissen liegt ein Fehler vor. Die Testdaten, also die Testalgorithmen, die Testvektoren und die Sollergebnisse liegen dabei in einem internen oder externen Speicher vor oder werden von einer übergeordneten Einheit geladen. Es ist bei dieser Teststrategie notwendig, dass ein jeder Testalgorithmus mindestens zweimal berechnet wird, wobei beim zweiten Mal die als Vergleicher ausgestalteten PAEs an einer anderen Kante liegen (vorzugsweise der gegenüberliegenden), um eine Ausführung des Testalgorithmusses auf allen PAEs zu gewährleisten. Ebenfalls ist es denkbar, dass die Vergleicher im Inneren des PAE-Arrays angeordnet sind und von links und rechts (oben und unten) jeweils ein Testalgorithmus A und B je ein Ergebnis A und B berechnet, wobei die Ergebnisse den Vergleichen zugeführt werden und übereinstimmen müssen.
Abhängig von der Art des Testalgorithmusses kann die fehlerhaft PAE anhand des Fehlers zurückverfolgt werden oder nicht. Unterstützt der Algorithmus eine Zurückverfolgung , so werden die entsprechenden Multiplexer-Zustände der Zeile/Spalte in der sich die defekte PAE befindet geändert und den Multiplexern zugeführt. Der Testalgorithmus, bei dem der Test fehlschlug wird erneut ausgeführt um eine Fehlerfreiheit, die nun gegeben sein sollte zu überprüfen. Ist der Baustein weiterhin fehlerhaft, muß überprüft werden, ob eventuell weitere oder andere PAEs defekt sind. Dabei ist die Ausführung des Testalgorithmusses und die Generierung der dem Fehler angepaßten Mültiplexerzustände iterativ.
Üblicherweise ist es nicht ausreichend nur einen Testalgorithmus zu implementieren, vielmehr müssen mehrere unterschiedliche Testalgorithmen implementiert sein, die jeweils mit mehreren Testvektoren geprüft werden. Nur so ist eine maximale Fehlererkennungsrate zu erreichen. Gleichzeitig muß die Busvernetzung von Testalgorithmus zu Testalgorithmus geändert werden, damit auch die Bussysteme ausreichend geprüft werden.
Auf die verschiedenen Ausführungen der Testalgorithmen wird in nicht nähers eingegangen, da dies für das erfindungsgemäße Grundverfahren nicht relevant ist.

### 2.1.5 Interne Steuerung des Selbsttests

Bausteinen wie DE 196 51 075.9-53, DPGAs, Kress-Arrays, Systolische Prozessoren und RAW-Machines gemeinsam ist ein integrierter Speicher, der einem oder mehreren PAEs zugeordnet ist und die Funktion des/der Rechenwerke bestimmt.
Entsprechend des BIST Grundprinzips wird der Speicher um einen Bereich (TestMEM) erweitert, der die Testalgorithmen und -vektoren enthält. Dabei kann dieser Speicher fest in Form eines ROMs oder wiederbeschreibbar mittels (E)EPROM, Flash-ROM, NV-RAM oder ähnlichem ausgestaltet sein.
Um einen Selbsttest durchzuführen wird an eine Speicherstelle innerhalb des TestMEM gesprungen und die dort abgelegte Testroutine ausgeführt (Internal Driven Self Test = IDST). Dabei sind außer der Erweiterung des Speichers (um den TestMEM) und einer Auswerteeinheit für die bereits beschriebenen Vergleicher (ErrorCHK) keine weiteren BIST-typischen Zusatzbaugruppen auf dem Chip notwendig.

### 2.1.6 Externe Steuerung des Selbsttests

Durch die Verringerung der Baugruppen auf eine Speichererweiterung (TestMEM) und einer Auswerteeinheit der Vergleicher (ErrorCHK) wird eine weitere noch kostengünstigere und platzsparendere Variante ermöglicht. Dabei wird kein interner TestMEM implementiert, vielmehr wird der gewöhnliche interne Speicher von außen mit dem Testalgorithmus und den Testvektoren geladen (External Driven Self Test = EDST); das bedeutet, die BIST-Testdaten werden nach außen verlagert und wie ein normales Programm betrachtet. Danach wird der Testalgorithmus ausgeführt. Alternativ kann der Testalgorithmus auch während der Ausführung sucessive aus einem externen Speicher geladen und dekodiert werden. Lediglich die ErrorCHK-Einheit muß noch auf dem Chip integriert sein. Um den Testalgorithmus und die Testvektoren von außen in den/die chipinternen Speicher zu laden gibt es mehrere Möglichkeiten. Prinzipiell kann der Vorgang durch eine funktionell übergeordnete CPU oder Recheneinheit (HOST) erfolgen, in dem diese die Testdaten (Testalgorithmus und Testvektoren) auf den Chip lädt (Download) oder der Chip lädt die Testdaten selbständig aus einem externen (Dualported-)RAM oder Festspeicher wie ROM, (E)EPROM, Flash-ROM, NV-RAM, o.ä..

### 2.1.7 Überpüfung der Funktion zur Laufzeit

BIST-Verfahren nach den Stand der Technik führen den Selbsttest für gewöhnlich nur während der RESET-Phase, also kurz nach dem Anlegen der Spannung (dem Einschalten), des Chips durch. Im Gegensatz dazu ist es möglich bzw. sinnvoll die in dieser Schrift beschriebenen Verfahren während der Laufzeit der Programme auf den Chips durchzuführen. Beispielsweise kann ein kompletter Test des Chips während der RESET-Phase durchgeführt werden und jeweils ein Teil der vorhandenen Testdaten während der Ausführung des Anwenderprogrammes bzw. während sogenannter IDLE-Zyklen, das sind Zeiträume, in denen kein Programm auf den Chips läuft, bzw. der Chip im Wartezustand ist. Dies ist ohne weiteres möglich, in dem während den IDLE-Zyklen einer der Testalgorithmen im internen Speicher angesprungen wird, bzw. vom externen Speicher oder HOST in den Baustein geladen wird. Dabei ist es verständlicherweise möglich, aus der Mehrzahl der vorhandenen Testalgorithmen und Testdaten partiell einen oder mehrere auszuwählen, wobei die Anzahl der ausgewählten Testdaten anhand der Länge des IDLE-Zyklusses festgelegt werden kann. Es können so lange neue Testdaten geladen werden, bis der IDLE-Zyklus durch das Eintreffen neuer zu verarbeitender Daten oder eines neu abzuarbeitenden Programmes oder einer anderen Anforderung beendet wird.
Eine weitere Möglichkeit ist das feste Integrieren von Teststrategien in die Anwenderprogramme, um während der Verarbeitung des Anwenderprogrammes Tests durchzuführen.
In beiden Fällen werden die relevanten Daten, die sich im Array befinden, vor dem Aufruf der Testalgorithmen gesichert. Es bietet sich an, dass die Daten entweder in interne Speicherbereiche (vgl. PACT04) oder die extern angeschlossenen Speicher gesichert werden. Nach Ausführung der Testalgorithmen werden die Daten vor der normalen Programmverarbeitung zurückgelesen.

Eine Alternative zur Steigerung der Ausführungsgeschwindigkeit besteht darin, neben jedem Register (Reg-*n*, *n* ∈ N) ein zusätzliches, nur für die Testalgorithmen verwendetes, Register (TestReg-*n*, *n* ∈ N) zu implementieren. Vor Ausführung der Testalgorithmen, werden über Multiplexer/ Demultiplexer (Tore) die TestReg-*n* zugeschaltet und für den Test verwendet. Die Reg-*n* bleiben unverändert. Nach Ausführung der Testalgorithmen werden wieder die Reg-*n* zugeschaltet.

Sieht die Teststrategie vor, dass nur Zellen getestet werden, deren Daten im Folgenden nicht mehr relevant sind, kann auf das Sichern und Laden der Daten auch verzichtet werden.

### 2.1.8 Speicherung der Nummer der defekten PAE

Wird eine PAE (oder ein Bus) als defekt erkannt, muß deren (dessen) Nummer, also der Zustandvektor (Defektkennung) der zugeordneten Multiplexer gespeichert werden, zum einen um die Multiplexer anzusteuern, zum anderen um bei einem Neustart (RESET) des Chips sofort zur Verfügung zu stehen.
Hierzu kann die Defektkennung
1. Chip-intern in einem programmierbaren Festspeicher ((E)EPROM, Flash-ROM, NV-RAM o.ä.) gespeichert werden
2. extern in einem programmierbaren Festspeichern ((E)EPROM, Flash-ROM, NV-RAM o.ä.) gespeichert werden
3. extern im HOST, innerhalb des auszuführenden Programmes, in dessen programmierbaren Festspeichern ((E)EPROM, Flash-ROM, NV-RAM o.ä. oder auf anderen Speichermedien (magnetische, optische, etc.) gespeichert werden.

### 2.1.9 Automatische Generierung der Multiplexer-Zustände

Üblicherweise wird nach der Erkennung eines Defektes die defekte Zelle anhand des erkannten Fehlverhaltens zurückverfolgt. Das ist bei entsprechenden Testalgorithmen möglich, sofern ein zusätzlicher Algorithmus zur Zurückverfolgung des Fehlers existiert. Bei Kontrolle des Tests durch einen HOST kann die Zurückverfolgung auf dem HOST durchgeführt werden. Existiert jedoch kein HOST kann oftmals die Zurückverfolgung nicht innerhalb des defekten Chips integriert werden oder ist zu aufwendig.
Zur Lösung wird vorgeschlagen einen ladbaren Zähler vor jedem Dekoder zu integrieren. Im Normalfall wird in den Zähler die Nummer der defekten PAE geladen, wonach der Dekoder die Zustände der Multiplexer wie bereits beschrieben ansteuert. Ist unbekannt, welche PAE defekt ist, kann der Zähler bei PAE 0 oder PAE m beginnend jede mögliche potentiell fehlerhafte PAE ansprechen, indem nach jedem erfolglosen Test der Zählerzustand so lange (je nach Implementierung) um eine PAE verringert (von PAE m aus zählend) oder erhöht (von PAE 0 aus zählend) wird, bis die defekte PAE erreicht wird und der Test ordentlich abläuft. Der nun erreichte Zählerzustand wird als Zustandsvektor für die Ansteuerung der Multiplexer gespei-. chert und representiert die defekte PAE. Wird kein funktionsfähiger Zählerzustand festgestellt, liegt entweder ein anderer Fehler vor (evtl. in einer anderern Reihe/Spalte oder ein Busfehler) oder es ist mehr als eine PAE defekt.
Ein Nachteil beim Einsatz von Zählern ist, dass sämtliche Möglichkeiten permutiert werden müssen, bis die fehlerhafte PAE gefunden wurde.
Eine weitere Möglichkeit, die allerding mehr Implemetierungsaufwand erfordert, ist daher der Einsatz von LookUp-Tabellen, die anhand des gerade ausgeführten Testalgorithmusses und des entstandenen Fehlerzustandes in ErrorCHK die entsprechende defekte PAE auswählen. Dazu ist es jedoch notwendig, dass die Testalgorithmen und Lookup-Tabellen aufeinander abgestimmt sind. Auf die Abstimmung soll jedoch nicht weiter eingegangen werden, da diese sehr chipspezifisch und unabhängig vom Grundprinzip ist.

### 2.1.10 Besondere Ausgestaltung für Standard-Prozessoren (Pentium, MIPS, ALPHA, etc).

Aktuelle und zukünftige Prozessoren enthalten eine Mehrzahl an Integer- und Fließkommaeinheiten. Daher ist das beschriebene Verfahren direkt auf diese Bausteine anwendbar, in dem jeweils eine zusätzliche Einheit implementiert wird und für eventuelle Defekte zur Verfügung steht. Der Test der Prozessoren kann beim Hersteller, während des Startvorganges der Computer oder ebenfalls während der Laufzeit stattfinden. Besonders sinnvoll ist dabei ein Test während des Boot-Vorganges, also dem Starten des Rechners nach einem Reset, der bei PCs vom sogenannten BIOS (Basic Input Output System), durchgeführt wird. Dabei können die entsprechenden Zustandvektoren der Multiplexer entweder auf dem Prozessor oder in externen Speichern, beispielsweise der PC-internen batteriegepufferten Echtzeituhr (RTC) abgelegt werden.

### 3. Zusammenfassung

Das vorliegende Verfahren ermöglicht den Austausch defekter Einheiten, die in dieser Schrift als Rechenwerke ausgestaltet sind, jedoch generell jede beliebige Einheit eines Chips darstellen können, durch funktionstüchtige. Gleichzeitig wird ein Verfahren aufgezeigt, mit dessen Hilfe Selbsttests einfacher, kostengünstiger und vor oder während des Ablaufs des Anwenderprogrammes durchgeführt werden können. Dadurch wird die Ausfallsicherheit auch im Betrieb erheblich vergrößert, was insbesondere für ausfallkritische Anwendungen wie Kraftwerksbetriebe, Luft- und Raumfahrt oder Militär von besonderer Bedeutung ist.

### 4. Kurzbeschreibung der Diagramme

Die folgende Diagramme zeigen zur Verdeutlichung Ausführungsbeispiele des erfindungsgemäßen Verfahrens:
- Fig. 1: Grundschaltung
- Fig. 2: keine PAE defekt
- Fig. 3: PAE1 defekt
- Fig. 4: PAEm defekt
- Fig. 5: PAE3 defekt
- Fig. 6: Array aus PAEs mit PAERs
- Fig. 7: Fehlertolerantes Bussystem
- Fig. 7a: Prinzip eines Selbsttests erster Teil
- Fig. 7b: Prinzip eines Selbsttests zweiter Teil
- Fig. 8a: EDST in einem externen ROM integriert
- Fig. 8b: EDST in einen externen RAM-Bereich integriert
- Fig. 8c: EDST direkt vom HOST gesteuert
- Fig. 9: Beispiel eines chipinternen Speichers mit BIST-Funktion integriert in eine interne Steuereinheit nach DE 196 54 846.2
- Fig. 10: Beispiel eines fehlertoleranten Standard-Prozessors
- Fig. 11: Ablaufdiagramm eines Selbsttests
- Fig. 12: Ablaufdiagramm der Generierung neuer Multiplexer Zustandsvektoren
- Fig. 13: Ablaufdiagramm eines Selbsttest während des IDLE-Zyklusses
- Fig. 14: Ablaufdiagramm eines in das Anwendungsprogramm integrierten Selbsttests
- Fig. 15: Lookup Table zur Fehlerkorrektur
- Fig. 16: Beispiel eines fehlertoleranten Bussystems
- Fig. 17: Sichern von Registern Reg-n in chipinterne Speicher vor dem Ausführen der Testalgorithmen
- Fig. 18: Sichern von Registern Reg-n in externe Speicher vor dem Ausführen der Testalgorithmen
- Fig. 19: Abschalten der Reg-n und Zuschalten der TestReg-n vor dem Ausführen der Testalgorithmen

### 4.1 Detailbeschreibung der Diagramme

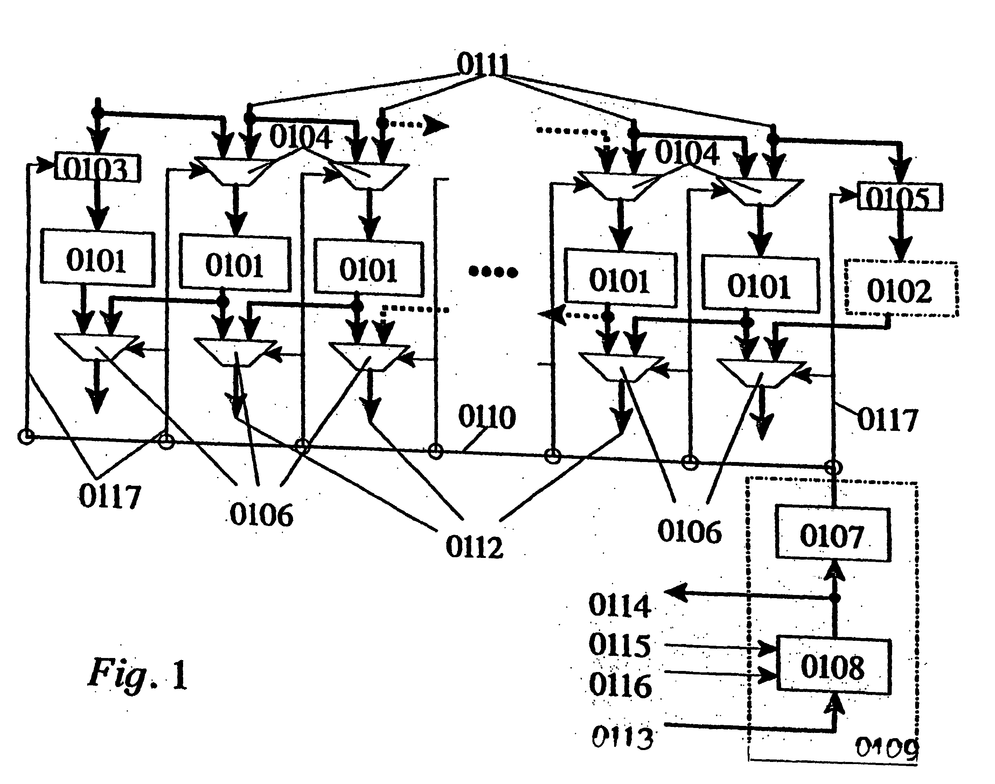

Fig. 1 zeigt das Grundprinzip der fehlertoleranten Verschaltung. Alle PAEs (0101) sind in einer Reihe angeordnet, der letzten PAE ist die zusätzliche PAER (0102) zugeordnet. Vor der ersten PAE in der Reihe ist ein Tor (0103) geschaltet, das die Daten zu der PAE sperrt, sofern diese PAE defekt ist. Ebenfalls ist vor die PAER (0102) ein Tor (0105) geschaltet, das die Daten zur PAER sperrt, wenn diese nicht benötigt wird (oder defekt ist). Die beiden Tore (0103 und 0105) sind optional und nicht zwingend erforderlich. Die Eingangsbusse (0111), die aus einer Mehrzahl von Einzelssignalen zusammengesetzt sind, werden über Multiplexer (0104) und die Tore (0103 und 0105) an die PAEs geleitet. Dabei könnnen die Daten ab einem Defekt um jeweils eine PAE nach rechts verschoben werden, bis zur PAER. Den Ausgangsbussen (0112), die aus einer Mehrzahl von Einzelssignalen zusammengesetzt sind, vorgeschaltet befinden sich ebenfalls Multiplexer (0106) die die Ergebnisse im Falle eines Fehlers wieder um eine Position nach links schieben, so dass der Fehler für das Ergebnisbussystem (Menge aller 0112) nicht erkennbar ist. Die einzelnen Ansteuersignale (0117) für die jeweiligen Multiplexer und Tore sind zu einem Bus (0110) zusammengefaßt und werden von einem Dekoder (0107) generiert. Der Dekoder erhält die Nummer der defekten PAE von der Einheit 0108, die entweder als Register oder als ladbarer Zähler ausgestaltet ist. Beim Einsatz einer Lookup-Tabelle zum Feststellten der defekten PAE aus dem von ErrorCHK generierten Fehler ist 0108 als Register implementiert, in das die Nummer der defekten PAE geladen wird. Wird die fehlerhafte PAE über eine Permutation gesucht, stellt 0108 einen ladbaren Zähler dar, der ausgehend von 0 alle möglichen PAEs durchzählt, bis die Fehlerhafte gefunden wurde. Ist die Fehlerhafte bekannt, wird sie beim nächsten RESET-Vorgang direkt in den ladbaren Zähler geladen. Zum Laden des Zählers oder Registers (0108) steht das Lade-Signal LOAD (0115) zur Verfügung. Um den Zähler hochzuzählen wird das Signal COUNT (0116) zum Zähler geführt. Über die Signale 0114 wird das Ergebnis des Zählers zur Speicherung zurückgeführt. Die Ansteuerung des Zählers/Registers und die Steuerung des zeitlichen Ablaufs wird von einer nicht gezeichneten Statemachine, einem externen HOST oder einer Vorrichtung gemäß DE 196 54 846.2 übernommen.

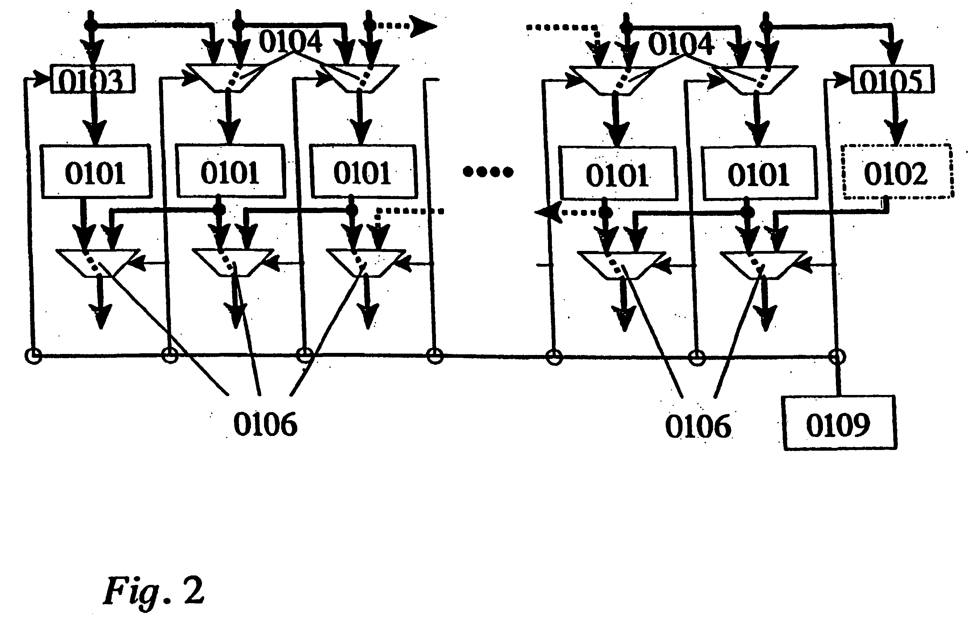

In Fig. 2 sind die Zustände der Multiplexer (0104 und 0106), sowie der Tore (0103 und 0105) angezeigt, wobei keine PAE defekt ist und die PAER (0102) nicht verwendet wird.

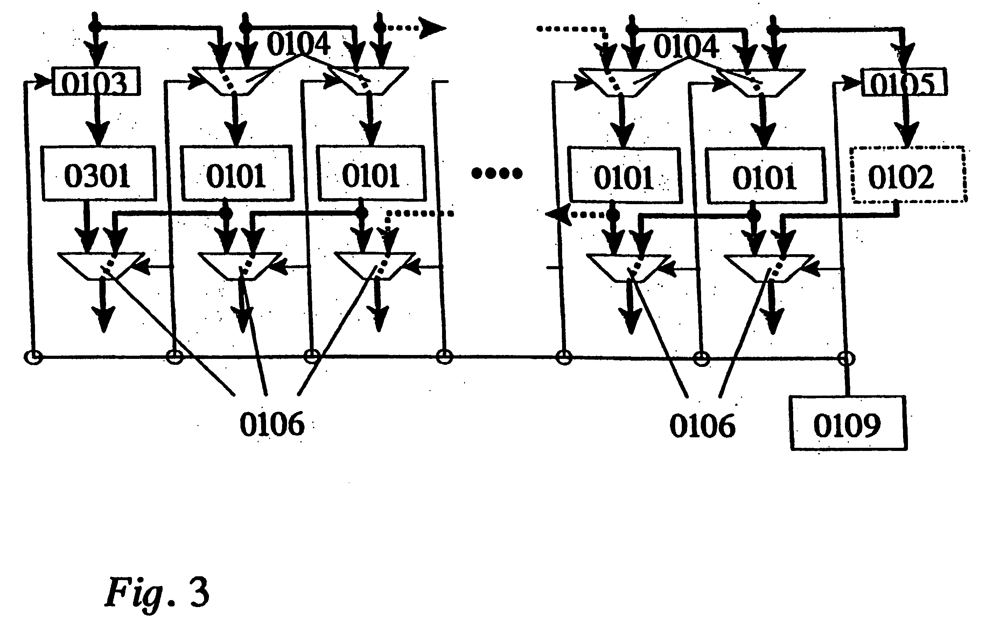

In Fig. 3 sind die Zustände der Multiplexer (0104 und 0106), sowie der Tore (0103 und 0105) angezeigt, wobei die PAE 1 (0301) defekt ist und die PAER (0102) verwendet wird.

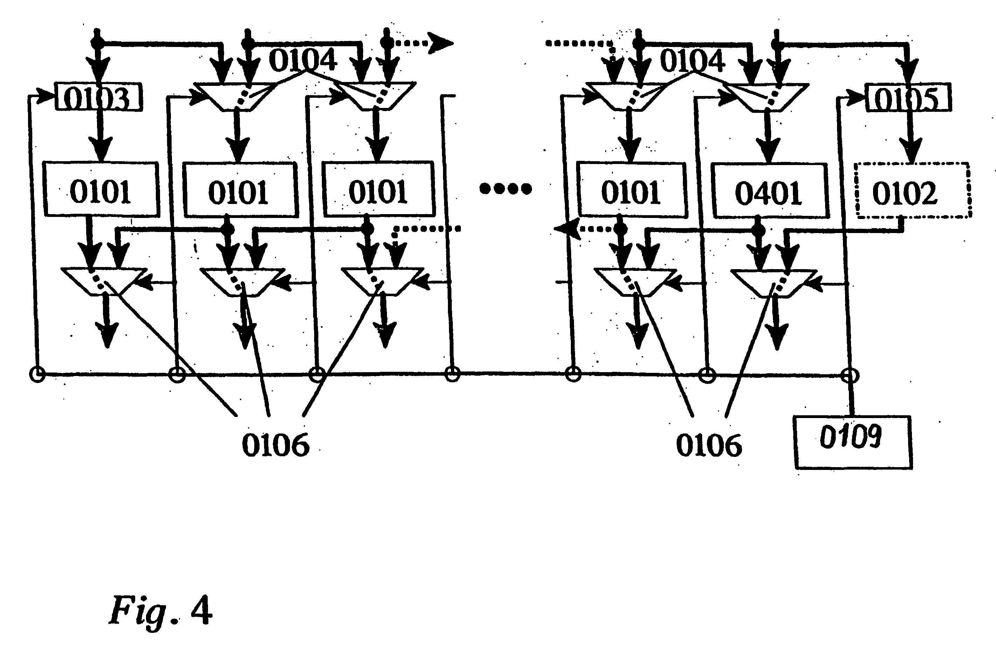

In Fig. 4 sind die Zustände der Multiplexer (0104 und 0106), sowie der Tore (0103 und 0105) angezeigt, wobei die PAE m (0401) defekt ist und die PAER (0102) verwendet wird.

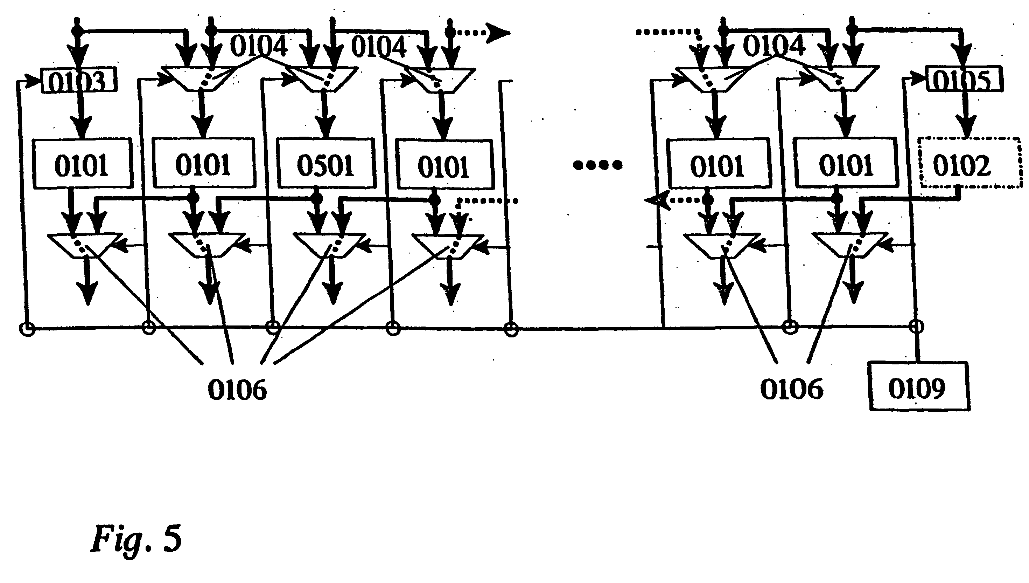

In Fig. 5 sind die Zustände der Multiplexer (0104 und 0106), sowie der Tore (0103 und 0105) angezeigt, wobei die PAE 3 (0501) defekt ist und die PAER (0102) verwendet wird.

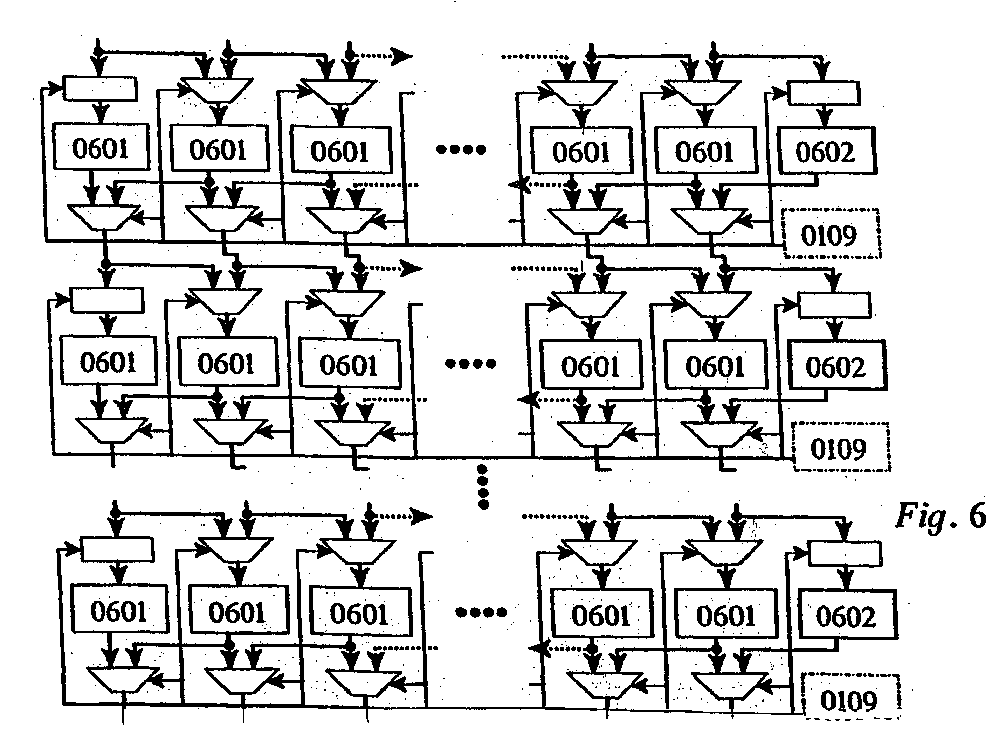

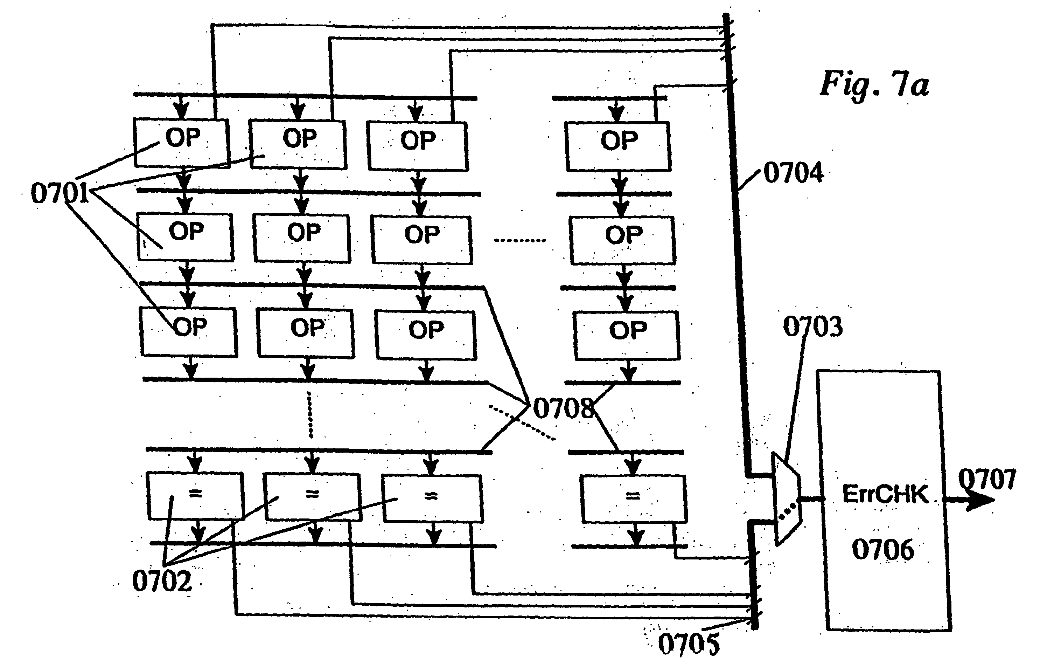

Fig. 6 zeigt ein Array aus PAEs (0601), wobei je einer PAE-Zeile eine PAER (0602) zugeordnet ist und jede Zeile eine separate Ansteuerung (0109, vgl. Fig. 1) besitzt. Dabei können eine Mehrzahl von Ansteuerungen auch zu einer einzigen den Zeilen übergeordneten Ansteuerung zusammengefaßt sein.

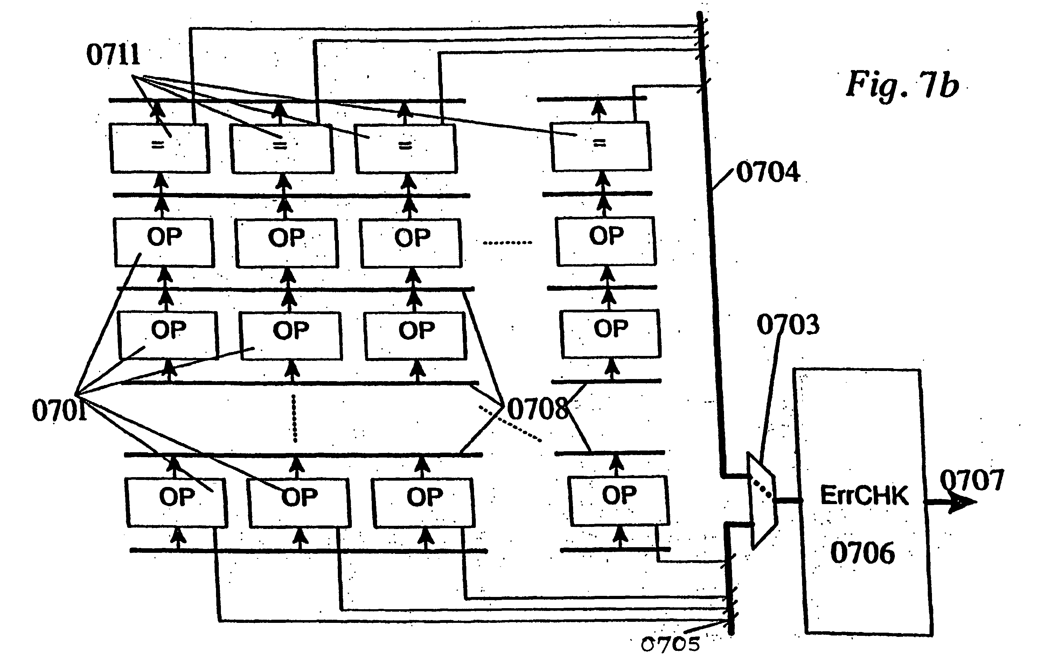

Fig. 7a zeigt einen möglichen ersten Test eines Algorithmusses. Dabei sind eine Mehrzahl von PAEs als Rechenelemente (0701) konfiguriert, die jeweils ihre Operation über einen Testvektor durchführen. Dabei sind die PAEs über Bussysteme (0708) beliebiger Ausgestaltung miteinander verbunden. Eine Reihe der PAEs (0702) ist als Vergleicher konfiguriert. Die in den Rechenelementen berechneten Werte werden in den Vergleichern mit einem vorgegebenen Wert verglichen. Stimmen beide Werte nicht überein, liegt ein Fehler vor. Die Ergebnisse der Vergleiche werden über ein Bussystem (0705) an einen Multiplexer (0703) geführt, der so geschaltet ist, dass er die Ergebnisse der Vergleiche aus (0702) an eine beliebig ausgestaltete Einheit (ErrorCHK 0706) zum Feststellen eines Fehlers und eventuell dessen Auswertung weitergereicht wird. Die Fehlerauswertung (0706) gibt ihr Ergebnis über den Bus (0707) an den HOST oder die steuernde Statemachine weiter (vgl. Fig. 1).

Fig. 7b zeigt einen zweiten Test der über die selbe Matrix aus PAEs durchgeführt wird wie Fig. 7b. Der auszuführende Algorithmus ist derselbe, ebenso wie die zu berechnenden Werte. Dabei sind jedoch die PAEs der Zeile 0702 als normale Rechenelemente ausgestaltet, wobei jedoch die erste Zeile der vorher (Fig. 7a) als Rechenwerke geschalteten PAEs (0701) nun als Vergleicher (0711) ausgestaltet sind. Die Datenflußrichtung auf den Bussystemen ist um 180° gedreht. Der Multiplexer (0703) ist so geschaltet dass die Ergebnisse der (gespiegelten) Vergleicher (0711) an die Fehlerauswertung (0706) weitergeleitet wird. Durch die Spiegelung der Vergleicher (0702 - 0711) wird erreicht, dass jede PAE tatsächlich in ihrer Funktion getestet wird. Würde die Spiegelung nicht durchgeführt werden, wird in einer PAE-Reihe (0702 oder 0711) nur die Funktion des Vergleiches, nicht jedoch jede beliebige Funktion getestet.

Die Implementierung eines weiteren Verfahrens als das den Fig. 7a und 7b zugrundeliegende kann unter Umständen sinnvoll sein. Dabei wird die Matrix in drei Gruppen unterteilt, einer Oberen, einer Mittleren und einer Unteren. In der oberen und unteren Gruppe werden Ergebnisse berechnet, wobei der Datenfluß der oberen Gruppe nach unten, der der unteren Gruppe nach oben gerichtet ist. Die mittlere Gruppe ist als Vergleicher konfiguriert und vergleicht die berechneten Werte der oberen Gruppe mit denen der unteren Gruppe. Für gewöhnlich führen die obere und untere Gruppe dieselben Berechnungen durch. Sind die Ergebnisse an den Vergleichern unterschiedlich liegt ein Fehler vor. Auch bei diesem Verfahren ist darauf zu achten, dass die PAEs die als Vergleicher geschaltet sind in einer nächsten Konfiguration ausreichend auf ihre Fehlerfreiheit geprüft werden.

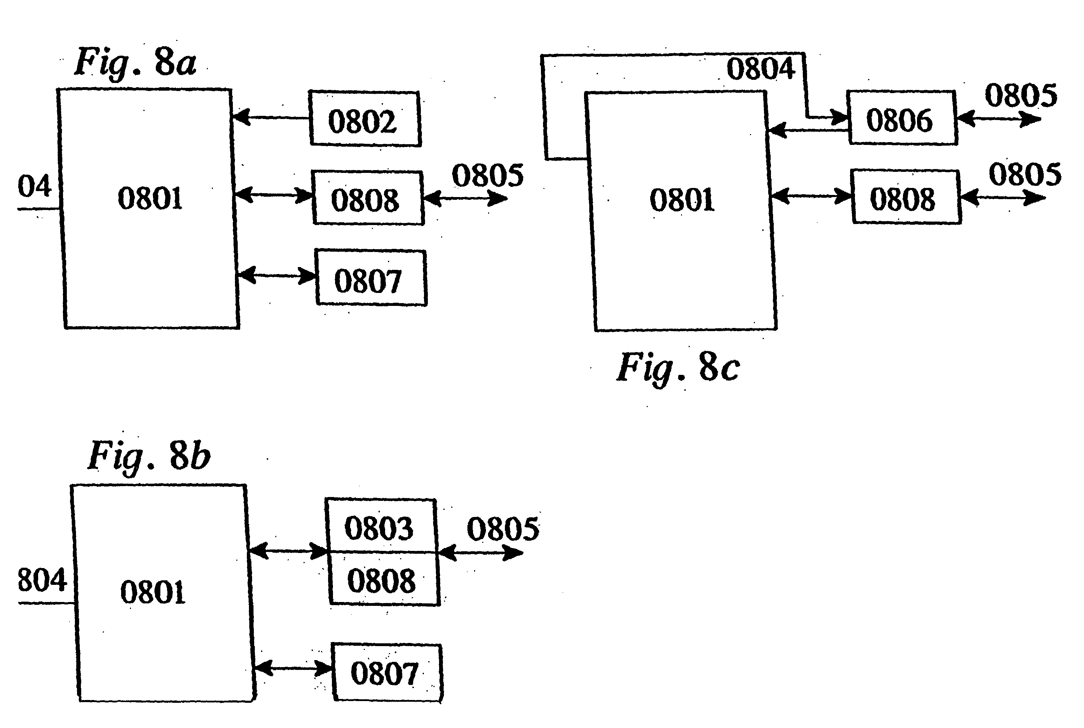

Die Figuren 8 zeigen mögliche Beschaltungen zum Test eines Chips (0801). Die Testdaten sind dabei extern gespeichert (EDST).
In Fig. 8a befinden sich die Testdaten in einem externen Festspeicher ((E)PROM, ROM, Flash-ROM, etc.) (0802). Die Daten liegen in einem RAM (0808) über den sie mit dem HOST (0805) ausgetauscht werden. Zur Speicherung der defekten PAEs, also der Zustandsvektoren der Multiplexer dient ein nicht flüchtiger Schreib-/Lese-Speicher (NV-RAM, EEPROM, Flash-ROM, usw.) (0807).
In Fig. 8b werden die Testdaten von einem HOST (0805)in einen Teil des RAM-Speichers (0803) geladen und von dort aus ausgeführt. Die Daten liegen in einem RAM (0808) über den sie mit dem HOST (0805) ausgetauscht werden. Ebenfalls möglich ist, dass der Chip selbst die Daten in den Speicherbereich (0803, 0808) lädt (ohne den Einsatz eines HOSTs), z.b. direkt von einem Massenspeicher. Zur Speicherung der defekten PAEs, also der Zustandsvektoren der Multiplexer dient ein nicht flüchtiger Schreib-/Lese-Speicher (NV-RAM, EEPROM, Flash-ROM, usw.) (0807).
Die in Fig. 8a/8b vom Chip generierten Fehler werden aus dem Baustein herausgeführt und sind extern verfügbar (0804).

In Fig. 8c werden die Testdaten schrittweise von einem HOST (0805) unter Verwendung einer geeigneten Schnittstelle (0806) zum Chip (0801) übertragen. Der Chip zeigt einen eventuellen Fehlerzustand (0804) durch die Schnittstelle (0806) dem HOST an. Die Daten liegen in einem RAM (0808) über den sie mit dem HOST (0805) ausgetauscht werden.

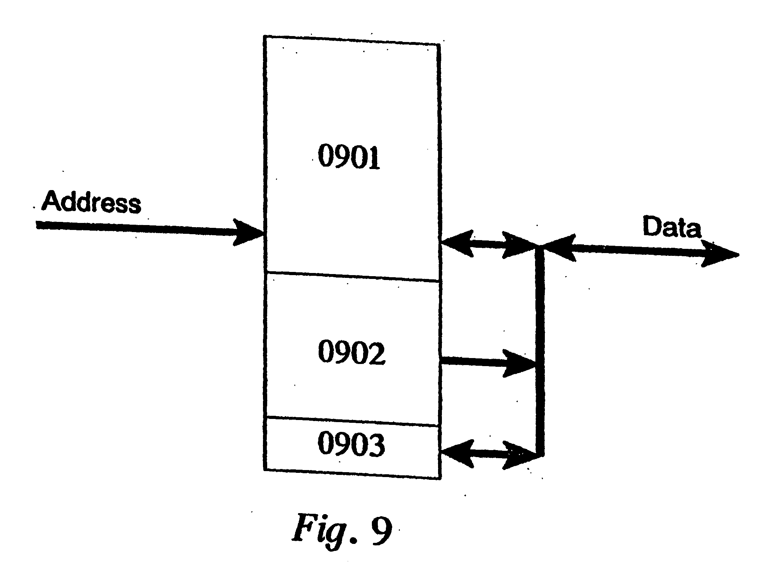

In Fig. 9 ist eine Erweiterung eines chipinternen Programm- bzw. Konfigurationsspeichers gemäß DE 196 54 846.2 um eine BIST-Funktion gemäß dem beschriebenen Verfahren dargestellt. Dabei ist der gewöhnliche Speicherbereich (0901) nach dem Stand der Technik durch einen Festspeicherbereich (0902), der für gewöhnlich als ROM implementiert ist - wobei auch eine Ausgestaltung als (E)EPROM, FLASH-ROM, NV-RAM usw. möglich wäre, erweitert, in dem die Testdaten, d.h. die Testalgorithmen und Testvektoren gespeichert sind. Am Ende des Speichers ist ein weiterer Speicherbereich (0903) hinzugefügt. Dieser ist wenige Einträge groß und beinhaltet die Adressen defekter PAEs und/oder defekter Busse, die in die Zähler/Register (0108) geladen werden. Dieser Speicherbereich ist als nicht flüchtiger Schreib-/Lesespeicher ausgestaltet (Flash-ROM, EEPROM, NV-RAM, usw.). Dadurch können die Daten beim RESET ausgelesen werden und nach dem Ablauf eines Testalgorithmusses, bei dem ein reparierbarer Fehler festgestellt wurde, mit den aktuellen Daten überschrieben werden. Diese Daten werden entweder je nach Implementierung von den Zählern (0108, Bus 0114) oder von den Lookup-Tabellen geliefert.

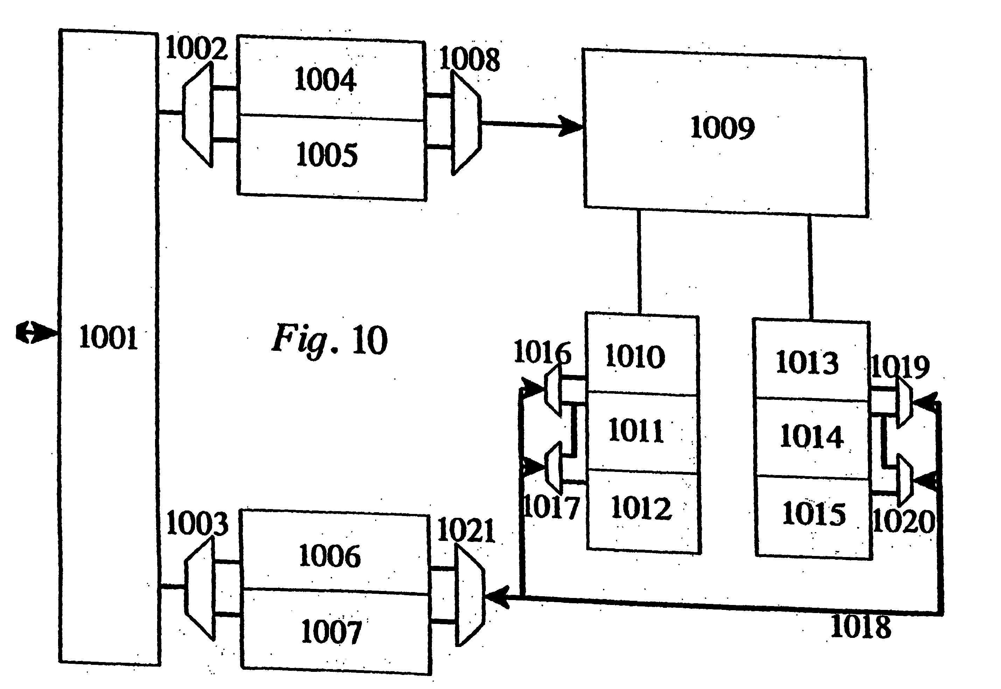

Fig. 10 zeigt das Beispiel eines Standard-Prozessors mit implementierter Fehlerbehebung. Über das Businterface (1001) ist der Prozessor gemäß dem Stand der Technik an seine Peripherie angebunden. Dem Businterface zugeordnet sind zwei Multiplexer (1002 und 1003), wobei 1002 zwei alternative Code-Caches (1004, 1005) und 1003 zwei alternative Daten-Caches (1006, 1007) so ansteuert, dass jeweils nur einer der Caches verwendet wird. Damit steht jeweils ein Cache zum Ausgleich von Defekten zur Verfügung und kann über die Multiplexer angesprochen werden. Der Code-Cache führt über einen Multiplexer (1008) zu der Kontrolleinheit (1009) des Prozessors, die in diesem Beispiel nur einmal existiert. Von der Kontrolleinheit werden die Integer-Rechenwerke (1010, 1011, 1012) und die Floating-Point-Rechenwerke (1013, 1014, 1015) gesteuert. Dabei werden jeweils zwei Rechenwerke im Betrieb verwendet, ein jeweils Drittes steht zur Verfügung, wenn jeweils eines der Rechenwerke ausfällt. Über die bidirektionalen Multiplexer (1016, 1017) werden jeweils 2 Integer-Rechenwerke dem Datenbus (1018) zugeschaltet, über die bidirektionalen Multiplexer (1019, 1020) werden jeweils 2 Floating-Point-Rechenwerke dem Datenbus (1018) zugeschaltet. Der Datenbus wird über einen bidirektionalen Multiplexer (1021) mit dem Datencache verbunden. Der Multiplexer 1003 ist ebenfalls bidirektional ausgestaltet. Die Ansteuerung der Multiplexer geschieht dabei nach dem bereits beschriebenen Verfahren. Dabei bilden die Multiplexer 1002, 1008, die Multiplexer 1003, 1021, die Multiplexer 1016, 1017, sowie die Multiplexer 1019, 1020 jeweils eine abhängige Gruppe.
Im Fehlerfall kann innerhalb des Beispielprozessors somit gemäß dem beschriebenen Verfahren der Daten- und Code-Cache, sowie jeweils ein Floating-Point- und Integer-Rechenwerk ersetzt werden.

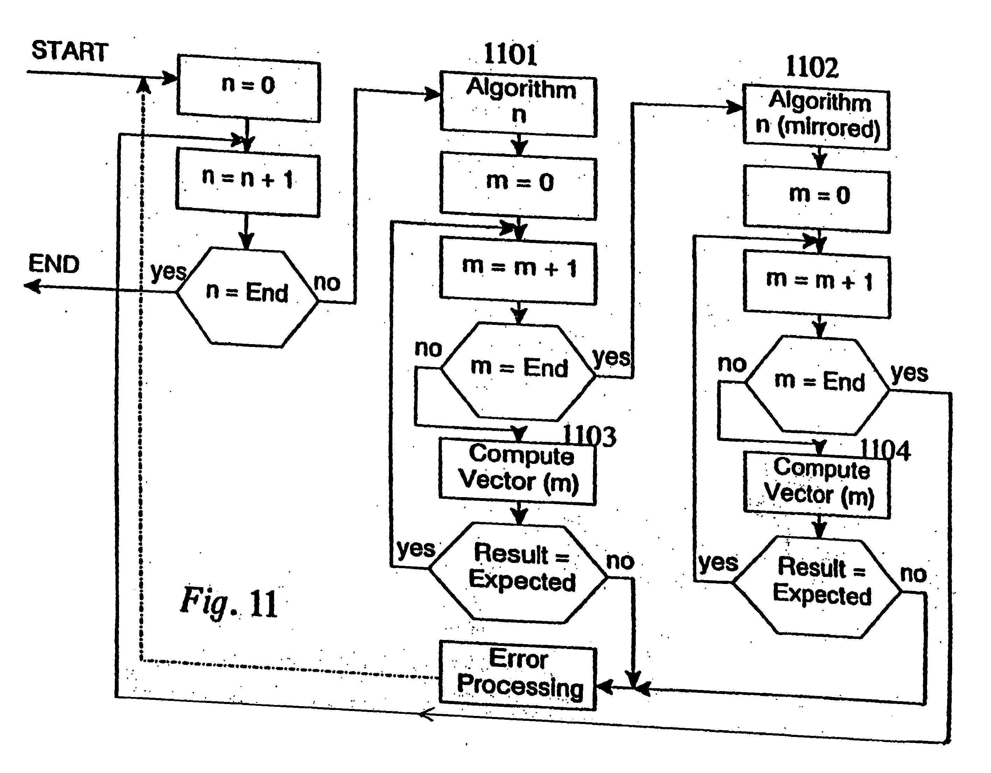

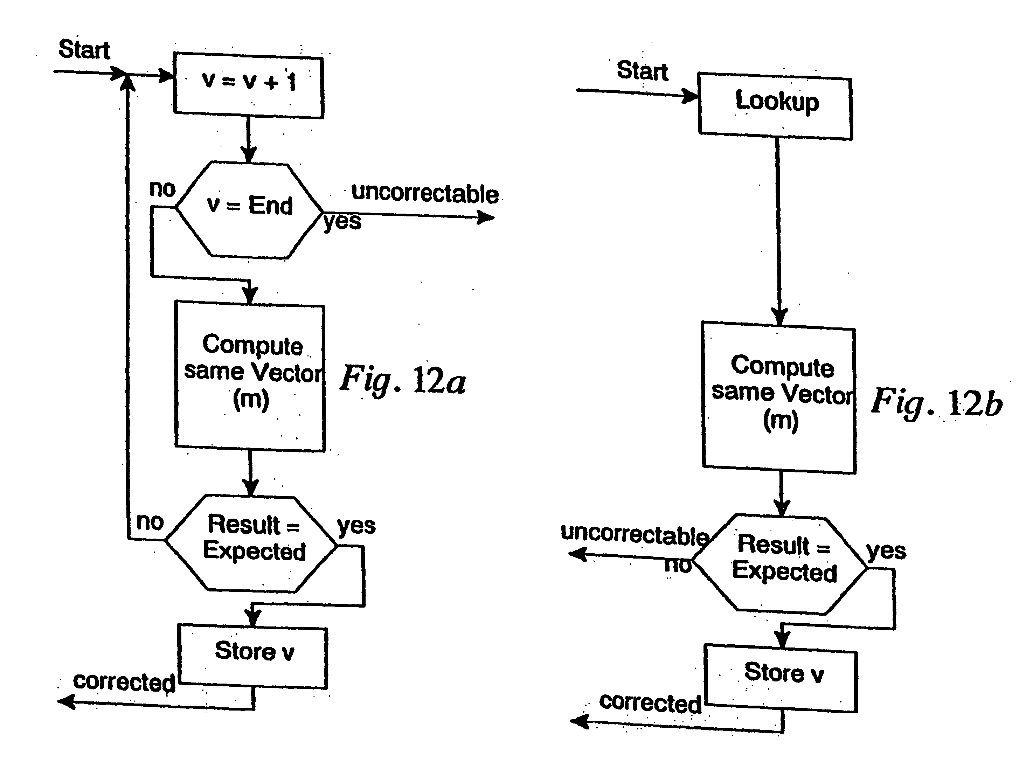

Der Ablauf eines Selbsttests ist in Fig. 11 dargestellt. Dabei ist die Variable n, n ∈ (1, 2, ... ), der Index aller Algorithmen und definiert den momentan verwendeten Algorithmus. Jeder Algorithmus liegt dabei in einer ersten Positionierung (1101), die Fig. 7a entspricht, und einer'zweiten gespiegelten Postitionierung (1102), die Fig. 7b entspricht, vor. Die Variable m, m ∈ (1, 2, ... ), ist der Index der zu berechnenden und zu vergleichenden Testvektoren. Innerhalb jedes Algorithmus wird die Menge der Testvektoren komplett durchgetestet und danach der Algorithmus gewechselt, entweder von 1101 nach 1102 oder von 1102 auf einen neuen Algorithmus (n = n + 1). Erreicht n den Wert nach dem letzten gültigen Algorithmus, wird der Test abgebrochen. Wird während der Berechnung (1103, 1104) der Testvektoren ein Fehler festgestellt, wird eine Fehlerbehandlung durchgeführt, die in Fig. 12a,b genauer erläutert wird. Nach erfolgreicher Fehlerbehandlung werden alle Algorithmen erneut getestet, um sicherzustellen, dass kein neuer Fehler durch die Korrektur entstand, wobei prinzipiell auch an der Stelle des momentan aktiven Algorithmus weitergetestet werden könnte.

Zur Fehlerbehandlung werden zwei Verfahren vorgeschlagen: Fig. 12a zeigt die Generierung neuer Multiplexer-Zustände über einen Zähler. Dabei ist die Variable v, v ∈ (0, 1, ... (Anzahl d. PAEs)), die Nummer der defekten PAE. Ist keine PAE defekt, gilt v = 0. Zunächst wird v so erhöht, dass die nächste PAE, vom PAE 1 beginnend, als defekt markiert wird. Danach wird der fehlgeschlagene Test nochmals ausgeführt. Läuft der Test korrekt ab, ist sichergestellt, dass die PAE v defekt ist und v wird in einen nicht flüchtigen Schreib-Lese-Speicher (z.B. 0903) geschrieben. Schlägt der Test erneut fehl, wird v so lange erhöht, bis entweder der Test korrekt abläuft oder v die Position hinter der letzten PAE erreicht und damit erwiesen ist, dass die fehlerhafte Gruppe von PAEs nicht korregiert werden kann, entweder weil der Fehler an anderer Stelle liegt (z.B. Bussystem), oder zwei oder mehrere PAEs defekt sind.
Fig. 12b zeigt eine weniger zeitaufwendige Möglichkeit. Dabei ist die bereits beschriebene Lookup-Tabelle integriert. Sie erhält als Eingangswert die Indizes m und n, sowie die Nummer des Vergleichers der den Fehler festgestellt hat. Diese Nummer wird von ErrorCHK (0706) über den Bus 0707 geliefert. Die Lookup-Tabelle liefert die Nummer v der defekten PAE zurück. Danach wird der fehlgeschlagene Test nochmals ausgeführt. Läuft der Test korrekt ab, ist sichergestellt, dass die PAE v defekt ist und v wird in einen nicht flüchtigen Schreib-Lese-Speicher (z.B. 0903) geschrieben. Schlägt der Test erneut fehl wird davon ausgegangen, dass ein irreparabler Fehler vorliegt.
Bei den meisten Testalgorithmen ist es möglich die Spalte der defekten PAE, jedoch nicht deren Zeile zu erkennen. Damit kann die Spalte der defekten PAE v ohne weiteres bestimmt werden, jedoch ist unbekannt, in welcher der Mehrzahl von Zeilen die defekte PAE liegt. Daher ist es in solchen Fällen notwendig die Fehlerbehandlung der Fig. 12a,b über alle Zeilen durchzuführen, die an der Berechnung des Testalgorithmusses beteiligt waren, so lange, bis der Fehler festgestellt wurde oder sämtliche Zeilen untersucht wurden und der Fehler unkorregierbar ist.

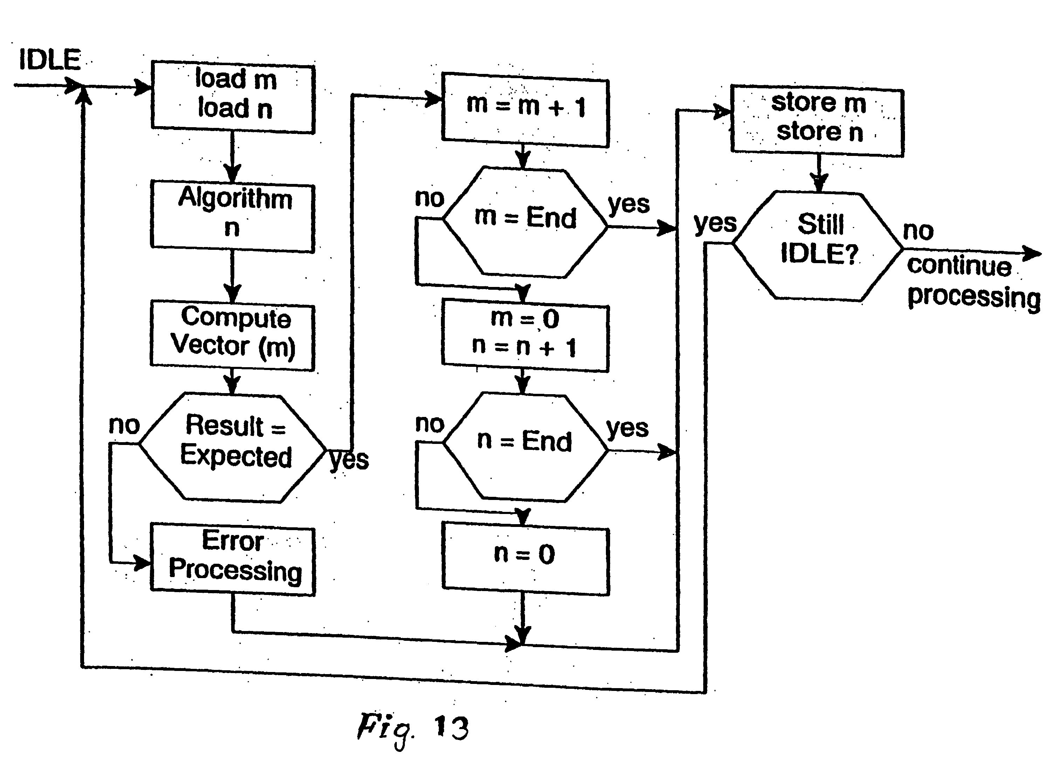

Fig. 13 zeigt eine Möglichkeit einen Chip-Test während IDLE-Zyklen, das sind Zyklen, während denen keine Programmausführung stattfindet, weil auf eine Aktion (beispielsweise eine Tastatureingabe) gewartet wird, durchzuführen. Für gewöhnlich werden derartige Zyklen durch Warteschleifen im Programmcode ausgedrückt. Es ist ohne weiteres möglich, bei Vorliegen einer solchen Wartebedingung eine Testroutine aufzurufen, die während der Wartezeit einen Test des Chips durchführt, wobei allerdings eine Echtzeitfähigkeit bei der Reaktion auf die zu wartende Aktion nicht mehr möglich ist. Die aus Fig. 11 bekannten Indizes m und n werden in Fig. 13 mit gleicher Bedeutung übernommen. Jedoch werden die Indizes im Datenspeicher abgelegt. Sämtliche relevanten Daten in dem Array werden vor dem Aufruf der Testroutine gesichert und nach der Ausführung der Testroutine wieder restauriert. Beim Aufruf der Testroutine werden die Indizes zunächst aus dem Datenspeicher geladen. Danach wird der entsprechende Algorithmus mit den entsprechenden Testvektoren ausgeführt. Ist das Ergebnis fehlerhaft findet eine Fehlerbehandlung gem. Fig. 12a,b statt. Ansonsten werden die Indizes neu berechnet und in den Datenspeicher zurückgeschrieben. Abschließend wird getestet, ob weiterhin ein IDLE-Zustand vorliegt, d.h. auf eine Aktion gewartet wird. Liegt weiterhin ein IDLE-Zustand vor, wird die Testroutine erneut angesprungen, wobei diesesmal eine andere Berechnung --- gemäß der bereits durchgeführten Neuberechnung der Indizes --- durchgeführt wird. Liegt kein IDLE-Zustand mehr vor, wird die Programmausführung normal weitergeführt.

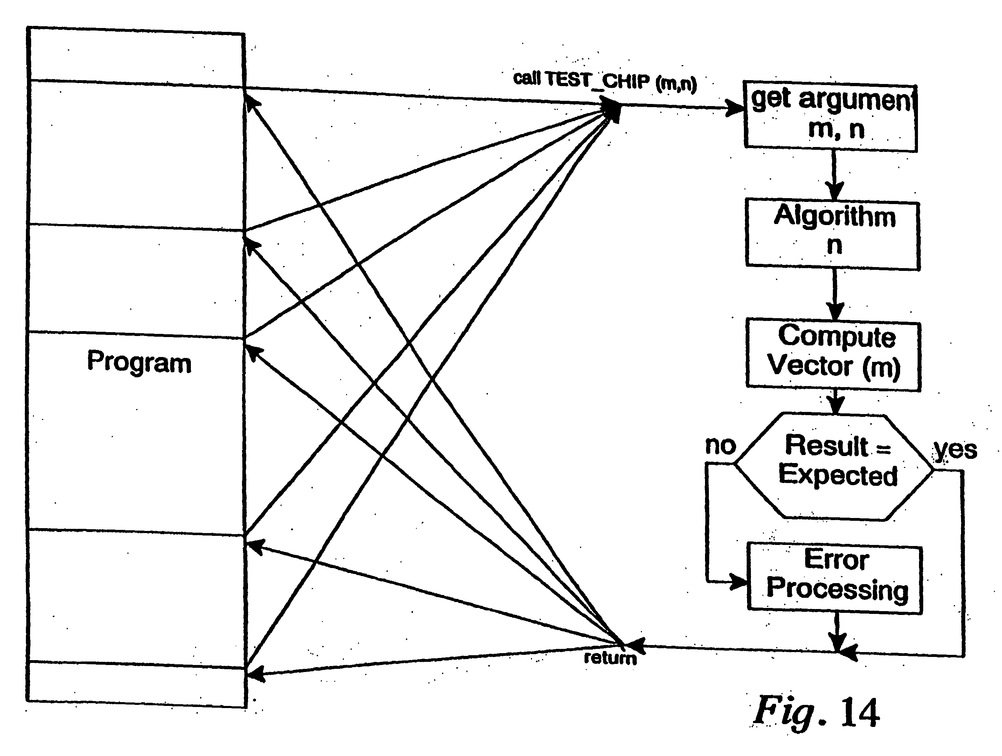

In Fig. 14 wird eine mögliche Abwandlung aus Fig. 13 dargestellt, in der die Testroutine direkt vom Anwenderprogramm aufgerufen wird (call TEST_CHIP (m,n)). Die Testroutine wird an bestimmten geeigneten Punkten im Algorithmus aufgerufen. Sämtliche relevanten Daten in dem Array werden vorher gesichert und nach der Ausführung der Testroutine wieder restauriert. Die Indizes m,n werden direkt beim Aufruf mitübergeben. Innerhalb der Routine TEST_CHIP wird Algorithmus n mit den Daten m ausgeführt. Der Fehlertest findet gemäß Fig. 11 und Fig. 13 statt. Am Ende von TEST_CHIP werden die Indizes im Gegensatz zu Fig. 11 und Fig. 13 nicht neu berechnet. Der Rücksprung aus der Routine TEST_CHIP führt auf die Position direkt hinter dem Aufruf "call TEST_CHIP", vergleichbar mit dem BASIC-Standard GOSUB ... RETURN.

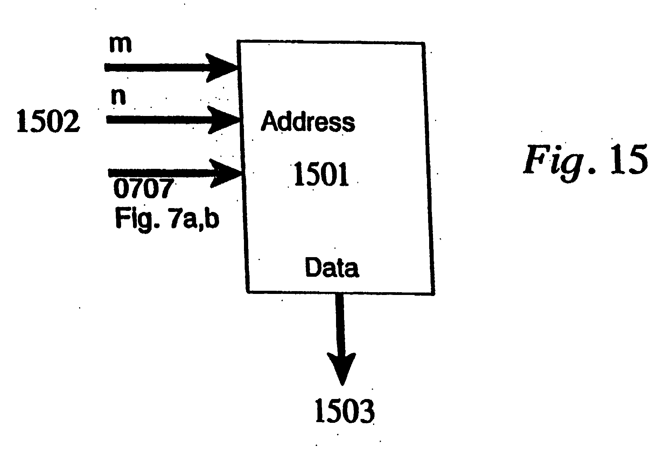

Eine mögliche Ansteuerung einer Lookup-Tabelle ist in Fig. 15 dargestellt. Die Lookup-Tabelle (1501) ist als ROM implementiert. Die Indizes m,n; also die Kennung des momentan durchgeführten Testalgorithmus, die Kennung der aktuellen Testdaten, sowie das Ergebnis (0707) der ErrorCHK-Einheit (0706) werden dem ROM als Adressen (1502) zugeführt. Die daraus resultierenden Daten (1503) geben die Nummer der defekten PAE an. Diese Nummer wird in die Register (0108) übertragen.

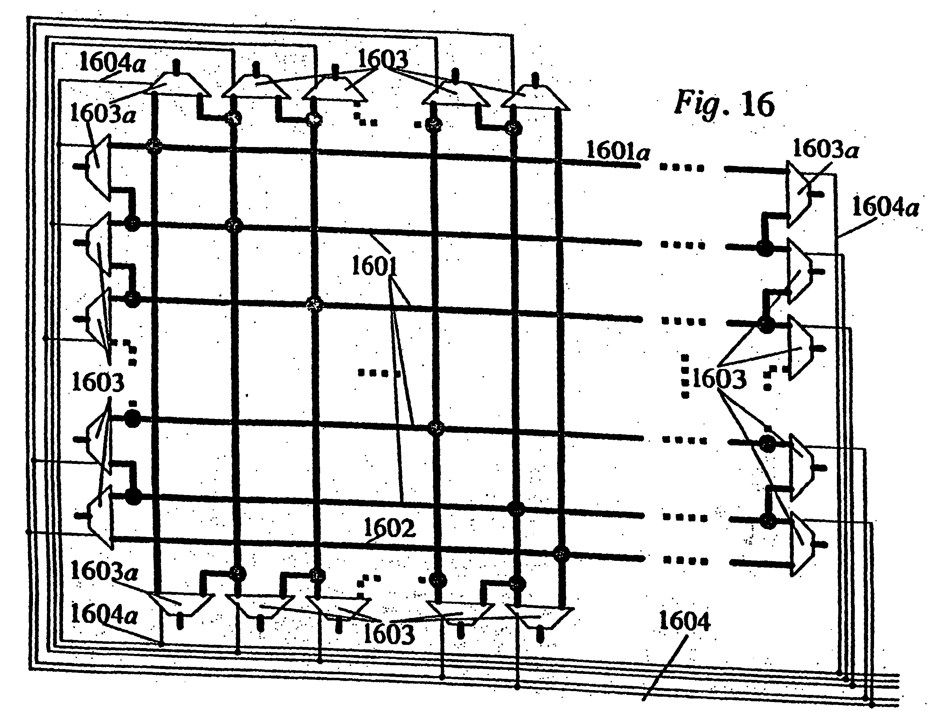

In Fig. 16 ist ein fehlertolerantes Bussystem dargestellt. Dabei ist einer Menge von gleichen Bussen (1601) ein zusätzlicher Bus (1602) zugeordnet. Das Bussystem besitzt Anschlüsse in allen vier Himmelsrichtungen. Über Multiplexer (1603) werden die Anschlüsse an die Busse so geschaltet, dass bei einem Ausfall eines Busses dessen Funktion durch den benachbarten (Darunterliegenden in der Horizontalen, bzw. Rechtsliegenden in der Vertikalen) Bus übernommen wird. Dabei werden alle Multiplexer die an einen bestimmten Bus geschaltet sind von derselben Steuerleitung angesprochen, beispielsweise werden die Multiplexer 1603a, die an den Bus 1601a angeschlossen sind von der Steuerleitung 1604a gesteuert. Die Steuerleitungen 1604 werden von einer Einheit entsprechend 0109 aus Fig. 1 angesteuert. Die weitere Ansteuerung und Fehlerbehandlung ist prinzipiell dieselbe, wie in den vorausgehenden Figuren beschrieben.

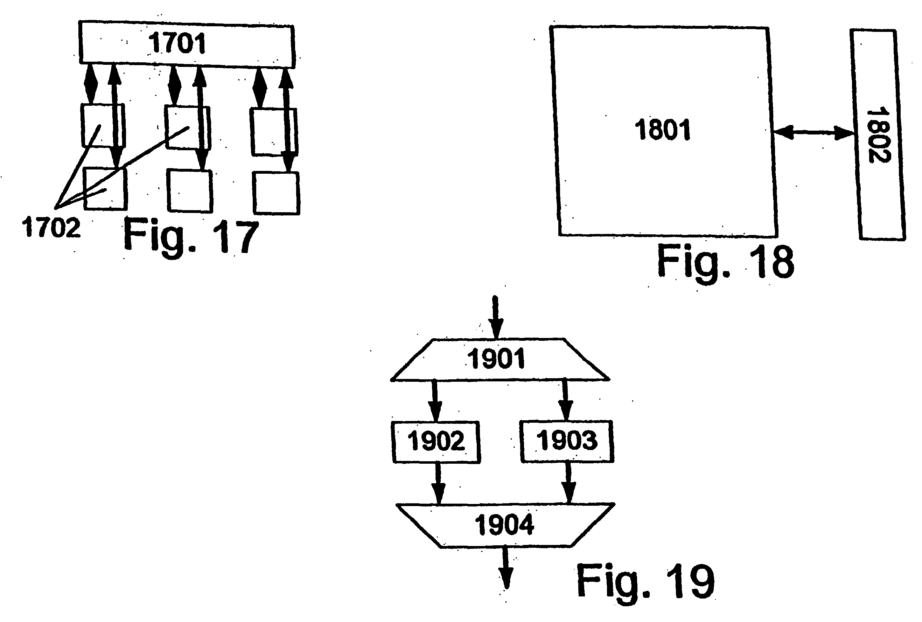

Fig. 17 zeigt die Zuordnung eines chipinternen RAMs oder RAM-Bereiches (1701) zu einer Gruppe von Zellen (1702). Vor dem Ausführen der Testalgorithmen werden die internen Register der Zellen (1702) in den RAM oder RAM-Bereich (1701) gespeichert. Nach dem Ausführen der Testalgorithmen werden die Daten in die internen Register der Zellen zurückgeschrieben. Das Schreiben und Lesen der Daten geschieht dabei über die Multiplexer/Tore (0103, 0104 und 0105). Dadurch werden die Daten, die aus einer defekten Zelle stammen, gemäß der Stellung der Multiplexer an die zum Ersatz zugeschaltete Zelle geschrieben. Der Ablauf des Anwenderalgorithmusses wird durch das Testverfahren nicht beeinträchtigt.

Fig. 18 zeigt das in Fig. 17 beschriebene System, jedoch werden die Daten der Zellen in dem Chip (1801) in einen externen Speicher (1802) geschrieben, bzw. aus dem externen Speicher gelesen.

In Fig. 19 ist die Verwendung von expliziten Testregistern TestReg-*n* dargestellt. Jedem internen Register Reg-*n* einer Zelle (1902) ist ein für die Testalgorithmen verwendetes Register TestReg-*n* (1903) zugeordnet. über die Demultiplexer (das Tor) (1901) wird selektiert, in welches Register geschrieben wird; über den Multiplexer (1904) wird selektiert, aus welchem Register gelesen wird. Dabei ist die Ansteuerung der (De-) Multiplexer (1901, 1904) derart, dass im normalen Betrieb, d.h. während des Ablaufes der Anwenderalgorithmen, das Reg-*n* (1902) selektiert wird und bei der Ausführung des Testalgorithmus das TestReg-*n* (1903) verwendet wird. Die Schaltung gemäß Fig. 19 ist für jedes relevante Register innerhalb einer Zelle implementiert.
Nachteil der Schaltung ist, dass die Daten einer defekten Zelle nicht der als Ersatz zugeschalteten zur Verfügung stehen. Zur Lösung des Nachteils wird vorgeschlagen mittels der (De-) Multiplexer (1901, 1904) eine zusätzliche Verschaltung entsprechend des erfindungsgemäßen Grundprinzipes (0103, 0104 und 0105) zu realisieren. Damit koennen sämtliche Daten der Ersatzzelle zur Verfügung gestellt werden.

Beschrieben wird somit zumindest auch ein Verfahren zur Reparatur von integrierten Schaltkreisen, wobei einer einzelnen oder einer Mehrzahl von Baugruppen eine weitere gleiche Zusatzbaugruppe zugeordnet ist, den Eingängen der Baugruppen ein Multiplexer vorgeschaltet ist, der den Eingangsbus einer Baugruppe auf die jeweils nachfolgende Baugruppe schalten kann, den Ausgängen der Baugruppen ein Multiplexer nachgeschaltet ist, der den Ausgangsbus einer Baugruppe von der jeweils nachfolgenden Baugruppe erhalten kann, im Fall eines Defektes in einer der Baugruppen die Multiplexer so geschaltet werden, dass die defekte Baugruppe durch ihre Nachfolgende ersetzt wird, wobei die nachfolgende Baugruppe durch deren Nachfolgende ersetzt wird, so lange, bis die letzte Baugruppe durch die Zusatzbaugruppe ersetzt wird. Dabei ist dann bevorzugt auch vorgesehen, dass die Ansteuerung der Multiplexer durch einen Dekoder erfolgt, der einen Binärwert so auskodiert, dass entweder alle Multiplexer gleich geschaltet sind oder zwei Gruppen von aufeinanderfolgenden Multiplexern entstehen, wobei die Multiplexer innerhalb einer Gruppe gleich geschaltet, die beiden Gruppen jedoch unterschiedlich geschaltet sind, so dass eine defekte Baugruppe von den Multiplexern ausgeschlossen wird. Es ist bei dieser Ausgestaltung möglich, dass der Binärwert von einem Zähler generiert wird. Dann kann auch vorgesehen werden, dass der Zähler im Fehlerfall so lange inkrementiert oder dekrementiert wird, bis die defekte Baugruppe erreicht ist, oder ein Endwert erreicht wird. Alternativ kann der Binärwert durch eine Lookup-Tabelle generiert werden. Die Lookup-Tabelle kann dann anhand des durchgeführten Testes und des erkannten Fehlers den Binärwert der defekten Baugruppe liefern. Die Binärwerte der defekten Baugruppe können in einem Chip-internen Speicher abgespeichert werden, um bei einem erneuten Start des Systems sofort zur Verfügung zu stehen und/oder die Binärwerte der defekten Baugruppe können in einem Chip-externen Speicher abgespeichert werden, um bei einem erneuten Start des Systems zur Verfügung zu stehen, wobei auch möglich ist, dass die Binärwerte der defekten Baugruppen von einer übergeordneten Einheit verwaltet werden und wobei insgesamt möglich ist, dass die Baugruppen Bussysteme darstellen.

Beschrieben wurde weiterhin ein Verfahren zum Test von integrierten Schaltkreisen, welches sich dadurch kennzeichnet, dass die Funktion des integrierten Schaltkreises getestet wird, indem ein Testprogramm ausgeführt wird, wobei Testvektoren berechnet werden und ein Fehler vorliegt, wenn der Vergleich der Ergebnisse mit einem vorgegebenen Soll-Ergebnis falsch ist, wobei bevorzugt möglich ist, dass in zwei- oder mehrdimensionalen Arrays aus mehreren Rechenwerken der Testalgorithmus mindestens einmal innerhalb des Arrays getauscht/gespiegelt wird und auch bevorzugt möglich ist, dass die Testdaten sich in einem bausteininternen Speicher befinden und/oder die Testdaten sich in einem bausteinexternen Speicher befinden, wobei insgesamt möglich ist, dass die Testdaten von einer übergeordneten Einheit geladen werden und/oder die Steuerung des Selbsttestes bausteinintern erfolgt und/oder die Steuerung des Selbsttestes durch eine übergeordnete Einheit erfolgt.

Der Selbsttest kann bei einem Start des Systems durchgeführt werden, und/oder während der Wartezyklen des ablaufenden Anwendungsprogrammes (IDLE-Zyklen) durchgeführt und/oder vom Anwendungsprogramm aus aufgerufen werden und/oder in ein Anwendungsprogramm integriert sein.

Es ist möglich, dass die sich in den Rechenwerken befindlichen Daten vor Ablauf des Testalgorithmusses in einem Chip-internen Speicher gesichert werden; nach Ablauf des Testes werden die Daten dann wieder aus dem Speicher geladen. Es ist auch möglich, dass die sich in den Rechenwerken befindlichen Daten vor Ablauf des Testalgorithmus in einem externen Speicher gesichert werden, nach Ablauf des Testes werden die Daten dann wieder aus dem externen Speicher geladen. Weiter ist möglich, dass die sich in den Rechenwerken befindlichen Register vor Ablauf des Testalgorithmus abgeschaltet und für den Test Testregister verwendet werden; ach Ablauf des Testes werden die Register dann wieder zugeschaltet.

### Begriffsdefinition

**Anwenderalgorithmus** Anwenderspezifisches Programm, das auf dem Chip abläuft.
**Ausgangsmultiplexer** Schaltung vergleichbar mit einem Relais, das zwischen mehreren möglichen Bussen an den Ausgängen von PAEs auswählt.
**BIST** Build In Self Test. In einen integrierten Schaltkreis implementierten Selbsttest, d.h. der TestMEM und alle Testfunktionen sind in den Schaltkreis eingeschlossen.
**Booten** (Boot-Vorgang) Das Laden eines Grundprogrammes und Einstellung der Grundfunktionen nach einem Reset.
**Bus** Bündelung aus mehreren Einzelsignalen / Einzelleitungen, die zusammen eine bestimmte Übertragungsfunktion erfüllen (Datenbus, Adressbus...)
**EDST** External Driven Self Test. In einen integrierten Schaltkreis implementierten Selbsttest, bei dem der TestMEM außerhalb des integrierten Schaltkreises angeschlossen ist und auch Teile der Steuerung außerhalb des Schaltkreises untergebracht sein können.
**Eingangsmultiplexer** Schaltung vergleichbar mit einem Relais, das zwischen mehreren möglichen Bussen an den Eingängen von PAEs auswählt.
**ErrorCHK** In einen integrierten Baustein implementierte Schaltung, die einen Fehler während BIST oder EDST erkennt und lokalisiert.
**HOST** Einem integrierten Schaltkreis übergeordnete Baugruppe oder Computer.
**IDLE** Zustand in dem ein Prozessor oder ähnlicher Schaltkreis auf eine Aktion wartet und keine Verarbeitung durchführt.
**Lookup-Tabelle** Speicher, der anhand einer Adresse ein fest definiertes Datenwort beliebiger Breite zurückliefert, zumeist als ROM oder ROM-ähnlichen Speicher implementiert.
**Nachbarbus** Bus, der direckt neben einem anderen Bus liegt und denselben Aufbau besitzt.
**PAE** Processing Array Element gemäß DE 196 51 075.9-53. Obwohl eine PAE in der Patentanmeldung DE 196 51 075.9-53 ein Rechenwerk darstellt, wird der Begriff in dieser Patentschrift allgemeiner für jede beliebige Zelle, also beispielsweise Rechenwerke, Statemachines, Speicher, gebraucht.
**PAER** Zelle, die zusätzlich auf dem integrierten Schaltkreis implementiert ist und ersatzweise für eine defekte Zelle gleicher Bauart verwendet werden kann.
**RESET** Das Setzen oder Rücksetzten eines integrierten Schaltkreises in einen definierten Grundzustand. Findet generell nach dem Anlegen von Spannung (Einschalten) statt.
**Selbsttest** Automatisches Testverfahren, das in einen integrierten Baustein implementiert ist.
**Sollergebnisse** Die Ergebnisse die von den Testalgorithmen geliefert werden müssen um die Korrektheit des integrierten Schaltkreises nachzuweisen. Stimmen die Sollergebnisse nicht mit den Berechnungen überein, liegt ein Fehler vor. Testalgorithmen Programm, das den integrierten Baustein testet; es enthält alle mathematischen Funktionen und Verschaltungen die überprüft werden sollen.
**Statemachine** Zustandsmaschine zur Ablaufsteuerung von komplexen Operationen, auch Sequenzer.
**Testalgorithmus** Programm zum Testen des Chips oder der Zellen einer Struktur.
**Testdaten** Die Menge aller Testalgorithmen, Testvektoren und Sollergebnissen.
**TestMEM** Speicher in dem die Testdaten abgelegt sind.
**Testroutine** Einzelner Programmabschnitt innerhalb der Testalgorithmen.
**Testvektoren** Daten, mit denen die Testalgorithmen ausgeführt werden.
**Tore** (Gates) Schalter die Daten weiterleiten oder sperren.
**Zellen** In sich abgeschlossene Baugruppe innerhalb eines integrierten Schaltkreises, beispielsweise Rechenwerke, Statemachines, Speicher.

## Patentansprüche

1. IC-Testanordnung mit einem HOST, einer Schnittstelle zum Chip, um darüber eventuelle Fehlerzustände dem HOST anzuzeigen und einem Speicher für Testdaten, **dadurch gekennzeichnet, dass** der Speicher zum chipveranlassten Laden von Testdaten als externer Speicher ausgebildet ist.

2. Verfahren zum Betreiben von Zellen aufweisenden integrierten Schaltkreisen wobei die Zellenfunktion des integrierten Schaltkreises getestet wird, indem mit den Zellen ein Testprogramm ausgeführt wird, in welchem Testvektoren berechnet werden, **dadurch gekennzeichnet, dass** Testdaten aus einem externen Speicher veranlasst vom integrierten Schaltkreis geladen werden, wobei mit wenigstens einer der Zellen ein Vergleich zwischen Testergebnis und Sollergebnis vorgenommen wird und ein Fehler angezeigt wird, wenn der Vergleich eine Abweichung zwischen Soll- und Testergebnis anzeigt.

3. Verfahren nach dem vorhergehenden Anspruch, **dadurch gekennzeichnet, dass** der Schaltkreis in einer Testanordnung getestet wird.

## Revendications

1. Dispositif d'essai de circuits intégrés comprenant un hôte, une interface vers la puce afin d'indiquer d'éventuels états d'erreurs à l'hôte et une mémoire de données de test, **caractérisé en ce que** la mémoire est réalisée en tant que mémoire externe pour le chargement de données de test par la puce.

2. Procédé pour l'exploitation de circuits intégrés présentant des cellules dans lequel la fonction des cellules du circuit intégré est testée par l'exécution d'un programme test avec les cellules et dans lequel des vecteurs de test sont calculés, **caractérisé en ce que** des données de test sont chargés du circuit intégré depuis une mémoire externe, une comparaison étant réalisée entre le résultat du test et un résultat théorique avec au moins une des cellules et une erreur étant indiquée lorsque la comparaison indique un écart entre le résultat théorique et le résultat du test.

3. Procédé selon l'une des revendications précédentes **caractérisé en ce que** le circuit est testé dans un dispositif d'essai.

## Claims

1. IC test assembly with a host, an interface with the chip for indicating any error states to the host, and a memory for test data, **characterised in that** the memory is designed as an external memory for the chip-induced loading of test data.

2. Method for operating integrated circuits having cells, wherein the cell function of the integrated circuit is tested by performing with the cells a test program in which test vectors are calculated, **characterised in that** test data are loaded from an external memory, induced by the integrated circuit, wherein with at least one of the cells a comparison is made between test result and nominal result and an error is indicated when the comparison indicates a deviation between nominal and test results.

3. Method according to the preceding claim, **characterised in that** the circuit is tested in a test assembly.
